# EUROPÄISCHE PATENTSCHRIFT

(11) **EP 3 074 267 B1**
(45) Veröffentlichungstag und Bekanntmachung des Hinweises auf die Patenterteilung: **27.01.2021**
(21) Anmeldenummer: 14802874.9
(22) Anmeldetag: 24.11.2014
(51) Int. Cl.: B60L 3/00, G01R 31/36, H01M 10/44, H02J 7/02, B60L 53/14, B60L 55/00, B60L 58/14, B60L 58/16, G01R 31/382

(54) **VERFAHREN UND VORRICHTUNG ZUR PRÜFUNG EINER TRAKTIONSBATTERIE EINES ELEKTROFAHRZEUGS**
METHOD AND APPARATUS FOR MONITORING A TRACTION BATTERY OF AN ELECTRIC VEHICLE
PROCÉDÉ ET DISPOSITIF DE SURVEILLANCE D'UNE BATTERIE DE TRACTION D'UN VÉHICULE ÉLECTRIQUE

(30) Priorität: 29.11.2013 AT 507862013
(43) Veröffentlichungstag der Anmeldung: 05.10.2016
(73) Patentinhaber: Omicron electronics GmbH, 6833 Klaus (AT)
(72) Erfinder: KLAPPER, Ulrich, A-6830 Rankweil (AT); JANKE, Oliver, 91334 Hemhofen (DE)
(74) Vertreter: Banzer, Hans-Jörg
(86) Internationale Anmeldenummer: PCT/EP2014/075408
(87) Internationale Veröffentlichungsnummer: WO 2015/078813

(56) Entgegenhaltungen:
- WO-A2-2010/051477
- DE-A1-102009 027 595
- DE-A1-102011 083 150
- US-A1- 2012 323 386

## Beschreibung

Die Erfindung betrifft Verfahren und Vorrichtungen zur Prüfung einer Traktionsbatterie eines Fahrzeugs. Die Erfindung betrifft insbesondere Verfahren und Vorrichtungen zur Prüfung einer Traktionsbatterie eines Elektrofahrzeugs, beispielsweise eines vollelektrischen Fahrzeugs oder eines Hybridfahrzeugs.

Elektrofahrzeuge gewinnen zunehmend an technischer und wirtschaftlicher Bedeutung. Als Elektrofahrzeuge werden Fahrzeuge mit einem Elektroantrieb verstanden. Der Elektroantrieb wird im Betrieb von einer Traktionsbatterie mit Energie versorgt. Die Traktionsbatterie kann beispielsweise mehrere miteinander verschaltete Akkumulatorenzellen oder Blöcke als Energiespeicher zum Antreiben des Elektrofahrzeugs umfassen. Das Elektrofahrzeug kann ein vollelektrisches Fahrzeug oder ein Hybridfahrzeug, das zusätzlich zu dem Elektroantrieb wenigstens einen weiteren Antrieb und ein dem weiteren Antrieb zugeordnetes Energiespeichersystem umfasst, sein.

In vielen herkömmlichen Elektrofahrzeugen kann die Traktionsbatterie über einen Ladestecker geladen werden. Zum Laden der Traktionsbatterie muss ein vollelektrisches Fahrzeug vorübergehend über den Ladenstecker mit einem elektrischen Netz verbunden werden, um die Traktionsbatterie des Elektrofahrzeugs aufzuladen. Auch Hybridfahrzeuge können vorübergehend über den Ladenstecker mit dem elektrischen Netz verbunden werden, um die Traktionsbatterie des Elektrofahrzeugs aufzuladen. In autarken Hybridfahrzeugen kann die Traktionsbatterie über den Verbrennungsmotor oder beim Bremsen (so genannte Rekuperation) geladen werden.

Die Entladung der Traktionsbatterie gewinnt in jüngerer Zeit an Bedeutung, beispielsweise im Kontext von so genannten V2G ("Vehicle-to-Grid")-Techniken, bei denen die Traktionsbatterie in ein elektrisches Netz entladen werden kann. Derartige Ansätze erlauben die Verwendung der Traktionsbatterie als Energiespeicher. In einem intelligenten Energienetz, das in der Technik auch als so genanntes "smart grid" bezeichnet wird, kann der Energiefluss zwischen dem elektrischen Netz und dem Elektrofahrzeug so umgekehrt werden, dass der Energiefluss von der Traktionsbatterie in das elektrische Netz erfolgt. Durch derartige Maßnahmen kann das elektrische Netz in Zeiten besonders hohen Lastaufkommens oder bei einem Ausfall eines eingeplanten Erzeugers, wie beispielsweise eines Windkraftwerks, kurzfristig gestützt werden. Durch gezielte Entladungen kann eine Anpassung der in dem elektrischen Netz verfügbaren Energie an den tatsächlichen Verbrauch erfolgen, wenn dieser beispielsweise von den Vorhersagen eines Energieversorgers abweicht. Das Laden und Entladen der Traktionsbatterie kann über einen kombinierten Lade-Entlade-Stecker des Elektrofahrzeugs erfolgen.

Die Traktionsbatterie stellt eine wichtige und teure Komponente des Elektrofahrzeugs dar. Aus verschiedenen Gründen ist es wünschenswert, die Traktionsbatterie prüfen und so ihren Zustand beurteilen zu können. Beispielsweise kann der Zustand der Traktionsbatterie, beispielsweise ihre Kapazität oder die bei einem V2G-Entladevorgang maximal verfügbare Energie, den Wert eines Elektrofahrzeugs auf dem Gebrauchtwagenmarkt wesentlich beeinflussen. Die Beurteilung des Zustandes der Traktionsbatterie basierend auf Daten eines Bordcomputers kann fehleranfällig sein. Darüber hinaus würde eine derartige Beurteilung eine Anpassung des Auslesevorgangs an die Ausgestaltung und Programmierung unterschiedlicher Bordcomputer erfordern. Dies erhöht den Aufwand und/oder die Fehleranfälligkeit bei der Beurteilung des Zustands der Traktionsbatterie. DE102009027595A1 betrifft die Gesundheitsdiagnose von Traktionsbatterien, wobei eine Rückführung von Energie an dem Fahrzeug an eine Energiestation unter Verwendung einer Lade- Entladevorrichtung vorgesehen ist.

Der Erfindung liegt die Aufgabe zugrunde, verbesserte Verfahren und Vorrichtungen zur Prüfung einer Traktionsbatterie bereitzustellen. Der Erfindung liegt insbesondere die Aufgabe zugrunde, derartige Verfahren und Vorrichtungen bereitzustellen, mit denen die für die Prüfung erforderliche Messung oder Datenerfassung über eine Schnittstelle erfolgen kann, die für unterschiedliche Elektrofahrzeuge eine einheitliche Ausgestaltung aufweist, wobei die Traktionsbatterie zur Prüfung nicht ausgebaut oder auf andere Weise freigelegt werden muss.

Nach Ausführungsformen der Erfindung werden Verfahren und Vorrichtungen mit den in den unabhängigen Ansprüchen angegebenen Merkmalen bereitgestellt. Die abhängigen Ansprüche definieren weitere Ausführungsbeispiele.

Nach Ausführungsbeispielen der Erfindung wird zur Prüfung der Traktionsbatterie ein Entladevorgang ausgelöst. Die Traktionsbatterie entlädt sich über eine Lade-Entlade-Schnittstelle des Fahrzeugs. Durch ein Überwachen und Auswerten des Entladevorgangs, das beispielsweise ein Erfassen und zeitliches Integrieren des Entladestroms oder der Leistung umfassen kann, kann der Zustand der Traktionsbatterie geprüft werden. Beispielsweise kann die Kapazität der Traktionsbatterie, ein Wirkungsgrad der Traktionsbatterie mit der ihr zugeordneten Lade-Entlade-Elektronik oder eine andere für die Beurteilung des Zustands der Traktionsbatterie charakteristische Größe bestimmt werden.

Da die Lade-Entlade-Schnittstelle für eine Kopplung mit Ladestationen eingerichtet sein muss, kann ein Prüfgerät eine Schnittstelle aufweisen, die für die Kopplung mit der Lade-Entlade-Schnittstelle des Elektrofahrzeugs eingerichtet ist. Die Anpassung der Lade-Entlade-Schnittstelle an die Konfiguration einer Ladestation ermöglicht, dass die Schnittstelle des Prüfgeräts für unterschiedliche Fahrzeugtypen und Fahrzeugtypen unterschiedlicher Hersteller einsetzbar ist. Eine Kenntnis der Ausgestaltung, Programmierung und/oder Versionierung der Programmierung eines Bordcomputers des Elektrofahrzeugs ist für die Prüfung der Traktionsbatterie nicht erforderlich.

Ein Verfahren zur Prüfung einer Traktionsbatterie eines Elektrofahrzeugs, die über eine Lade-Entlade-Schnittstelle sowohl ladbar als auch entladbar ist, umfasst ein Erzeugen eines Steuerbefehls zum Auslösen eines Entladevorgangs der Traktionsbatterie. Das Verfahren umfasst ein Überwachen des Entladevorgangs der Traktionsbatterie. Das Verfahren umfasst ein Ermitteln wenigstens einer Kenngröße der Traktionsbatterie abhängig von dem überwachten Entladevorgang.

Bei dem Verfahren wird die Tatsache, dass das Elektrofahrzeug über die Lade-Entlade-Schnittstelle auch entladen werden kann, dazu genutzt, die Traktionsbatterie zu prüfen. Beispielsweise kann die Batterie über den Ladestecker so vollständig geladen werden, wie es eine Lade-Entlade-Elektronik des Elektrofahrzeugs erlaubt, und anschließend so weit entladen werden, wie es die Lade-Entlade-Elektronik des Elektrofahrzeugs erlaubt. So kann beispielsweise der maximal netto verfügbare Energieinhalt der Batterie geprüft werden.

Der Steuerbefehl kann über die Lade-Entlade-Schnittstelle an das Elektrofahrzeug übermittelt werden. Es kann wenigstens eine Leitung zur Übermittlung von Steuerbefehlen in der Lade-Entlade-Schnittstelle und der damit koppelbare Schnittstelle des Prüfgeräts vorgesehen sein. Alternativ oder zusätzlich kann der Steuerbefehl als Signal auf die Versorgungsleitung aufmoduliert und von dem Elektrofahrzeug ausgelesen werden. Die Energieübertragung beim Entladen kann über einen Anschlusskontakt erfolgen, über den Befehle von einem Prüfgerät zu dem Elektrofahrzeug und/oder Daten oder andere Informationen von dem Elektrofahrzeug zu dem Prüfgerät übertragen werden.

Der Steuerbefehl kann nach einem V2G ("Vehicle-to-Grid")-Protokoll erzeugt werden.

Der Steuerbefehl kann ein Befehl des V2G-Protokolls sein, mit dem in einem V2G-Netzbetrieb ein Einspeisen von Energie von der Traktionsbatterie in ein elektrisches Netz, beispielsweise ein Gebäudenetz oder ein Energienetz, ausgelöst wird. Dies erlaubt die Verwendung der herkömmlichen definierten Befehle des V2G-Protokolls.

Der Steuerbefehl, mit dem bei der Prüfung der Entladevorgang ausgelöst wird, kann ein dedizierter Steuerbefehl sein, der nur für die Prüfung der Traktionsbatterie reserviert ist.

Der Steuerbefehl kann über eine von der Lade-Entlade-Schnittstelle verschiedene Schnittstelle des Elektrofahrzeugs an das Elektrofahrzeug übermittelt werden.

Bei dem Entladevorgang kann wenigstens ein Teil der in der Traktionsbatterie gespeicherten Energie in ein elektrisches Netz, beispielsweise ein Gebäudenetz oder ein Energienetz eines Energieversorgungsunternehmens, eingespeist werden. Dies reduziert die mit der Prüfung der Traktionsbatterie verbundenen Kosten, da die Energie nicht lokal dissipiert, sondern für andere Verbraucher bereitgestellt wird.

Das Überwachen des Entladevorgangs kann ein Erfassen der bei dem Entladevorgang aus der Traktionsbatterie entladenen elektrischen Ladung und/oder elektrischen Energie umfassen. Ein Entladestrom kann erfasst und zeitlich integriert werden, um die Energie und/oder Ladung zu ermitteln.

Das Ermitteln der wenigstens einen Kenngröße der Traktionsbatterie kann umfassen, dass die bei einem Entladevorgang insgesamt bereitgestellte elektrische Energie ermittelt wird. Das Ermitteln der wenigstens einen Kenngröße der Traktionsbatterie kann umfassen, dass eine Kapazität der Traktionsbatterie abhängig von der bei dem Entladevorgang aus der Traktionsbatterie entladenen elektrischen Ladung und/oder elektrischen Energie ermittelt wird.

Bei dem Verfahren kann die Batterie nicht nur entladen, sondern auch geladen werden. Das Ermitteln der wenigstens einen Kenngröße der Traktionsbatterie kann umfassen, dass ein Systemwirkungsgrad ermittelt wird, der ein Verhältnis zwischen der bei einem Entladevorgang insgesamt von der Traktionsbatterie über die Lade-Entlade-Schnittstelle bereitgestellten Energie zu der zum Laden benötigten Energie angibt.

Das Verfahren kann weiterhin umfassen, dass ein Ladevorgang der Traktionsbatterie ausgelöst und der Ladevorgang überwacht wird.

Zum Auslösen des Ladevorgangs kann ein weiterer Steuerbefehl an das Elektrofahrzeug übermittelt werden.

Die wenigstens eine Kenngröße der Traktionsbatterie kann abhängig von dem überwachten Ladevorgang und dem überwachten Entladevorgang ermittelt wird.

Das Verfahren kann von einem mobilen Prüfgerät ausgeführt werden.

Das Prüfgerät kann bei der Durchführung des Verfahrens über die Lade-Entlade-Schnittstelle des Fahrzeugs mit Energie versorgt werden.

In dem Prüfgerät kann wenigstens ein vordefinierter und/oder benutzerkonfigurierbarer Lastzyklus für den Entladevorgang hinterlegt sein. Die Prüfung der Batterie kann einen Entladevorgang gemäß einem Lastzyklus umfassen, bei dem eine Last an der Lade-Entlade-Schnittstelle, eine Geschwindigkeit und/oder eine Leistung beim Entladen zeitabhängig verändert wird.

Nach einem weiteren Ausführungsbeispiel wird eine Vorrichtung zur Prüfung einer Traktionsbatterie eines Elektrofahrzeugs, die über eine Lade-Entlade-Schnittstelle sowohl ladbar als auch entladbar ist, angegeben. Die Vorrichtung umfasst eine Schnittstelle zum Ausgeben eines Steuerbefehls, um einen Entladevorgang der Traktionsbatterie auszulösen. Die Vorrichtung umfasst eine mit der Lade-Entlade-Schnittstelle koppelbare Überwachungseinheit zum Überwachen des Entladevorgangs der Traktionsbatterie und zum Ermitteln wenigstens einer Kenngröße der Traktionsbatterie abhängig von dem überwachten Entladevorgang.

Die Vorrichtung kann als mobiles Prüfgerät, insbesondere als portables Prüfgerät, ausgebildet sein.

Die Vorrichtung kann für eine lösbare Kopplung mit der Lade-Entlade-Schnittstelle ausgestaltet sein.

Die Vorrichtung kann eingerichtet sein, um das Verfahren nach einem Ausführungsbeispiel auszuführen.

Die Vorrichtung kann eingerichtet sein, um den Steuerbefehl nach einem V2G ("Vehicle-to-Grid")-Protokoll zu erzeugen.

Die Vorrichtung kann eingerichtet sein, um zum Auslösen des Entladevorgangs bei der Batterieprüfung einen Befehl des V2G-Protokolls zu erzeugen, mit dem in einem V2G-Netzbetrieb ein Einspeisen von Energie von der Traktionsbatterie in ein elektrisches Netz ausgelöst wird.

Die Vorrichtung kann eingerichtet sein, um zum Auslösen des Entladevorgangs bei der Batterieprüfung einen dedizierten Steuerbefehl zu erzeugen, der ausschließlich für die Prüfung der Traktionsbatterie reserviert ist.

Die Vorrichtung kann eingerichtet sein, um den Steuerbefehl über die Lade-Entlade-Schnittstelle des Elektrofahrzeugs an das Elektrofahrzeug bereitzustellen.

Die Vorrichtung kann eingerichtet sein, um den Steuerbefehl über eine von der Lade-Entlade-Schnittstelle verschiedene Schnittstelle des Elektrofahrzeugs an das Elektrofahrzeug zu übermitteln.

Die Vorrichtung kann eingerichtet sein, um bei dem Entladevorgang wenigstens einen Teil der in der Traktionsbatterie gespeicherten Energie in ein elektrisches Netz, beispielsweise ein Gebäudenetz oder ein Energienetz eines Energieversorgungsunternehmens, einzuspeisen.

Die Überwachungseinheit kann eingerichtet sein, um eine aus der Traktionsbatterie entladene elektrische Ladung und/oder elektrische Energie zu erfassen. Die Überwachungseinheit kann eingerichtet sein, um einen Entladestrom zu erfassen und zeitlich zu integrieren.

Die Überwachungseinheit kann eingerichtet sein, um die bei einem Entladevorgang insgesamt bereitgestellte elektrische Energie zu ermitteln und eine Kapazität der Traktionsbatterie abhängig von der bei dem Entladevorgang aus der Traktionsbatterie entladenen elektrischen Ladung und/oder elektrischen Energie zu ermitteln.

Die Überwachungseinheit kann eingerichtet sein, um einen Ladevorgang der Traktionsbatterie auszulösen.

Die Überwachungseinheit kann eingerichtet sein, um einen Systemwirkungsgrad zu ermitteln, der ein Verhältnis zwischen der bei einem Entladevorgang insgesamt von der Traktionsbatterie über die Lade-Entlade-Schnittstelle bereitgestellten Energie zu der zum Laden erforderlichen Energie angibt.

Die Vorrichtung kann eingerichtet sein, um zum Auslösen des Ladevorgangs einen weiteren Steuerbefehl an das Elektrofahrzeug zu übermitteln.

Die Überwachungseinheit kann eingerichtet sein, um die wenigstens eine Kenngröße der Traktionsbatterie abhängig von dem überwachten Ladevorgang und dem überwachten Entladevorgang zu ermitteln.

Die Vorrichtung kann einen Speicher umfassen, in dem wenigstens ein vordefinierter und/oder benutzerkonfigurierbarer Lastzyklus für den Entladevorgang hinterlegt sein kann. Die Vorrichtung kann eingerichtet sein, um eine Last und/oder eine Leistung beim Entladevorgang gemäß dem Lastzyklus zeitabhängig zu verändern.

Nach einem weiteren Ausführungsbeispiel wird ein System angegeben, das ein Elektrofahrzeug mit einer Traktionsbatterie und eine Vorrichtung zur Prüfung der Traktionsbatterie umfasst. Das Elektrofahrzeug kann eine Lade-Entlade-Schnittstelle aufweisen, über die die Traktionsbatterie sowohl ladbar als auch entladbar ist. Die Vorrichtung zur Prüfung ist als Vorrichtung nach einem Ausführungsbeispiel ausgestaltet.

Bei Verfahren, Vorrichtungen und Systemen nach Ausführungsbeispielen kann die Lade-Entlade-Schnittstelle des Elektrofahrzeugs ein Lade-Entlade-Stecker sein. Die damit koppelbare Schnittstelle der Vorrichtung zur Prüfung der Traktionsbatterie kann ein Stecker mit korrespondierenden Anschlüssen sein.

Die Erfindung wird nachfolgend unter Bezugnahme auf die Zeichnungen anhand bevorzugter Ausführungsformen näher erläutert. In den Zeichnungen bezeichnen identische Bezugszeichen identische Elemente.
Figur 1 zeigt eine schematische Darstellung eines Systems mit einem Prüfgerät nach einem Ausführungsbeispiel.
Figur 2 ist ein Flussdiagramm eines Verfahrens nach einem Ausführungsbeispiel.
Figur 3 ist ein Flussdiagramm eines Verfahrens nach einem weiteren Ausführungsbeispiel.
Figur 4 ist ein Flussdiagramm eines Verfahrens nach einem weiteren Ausführungsbeispiel.
Figur 5 zeigt eine schematische Darstellung eines Systems mit einem Prüfgerät nach einem weiteren Ausführungsbeispiel.

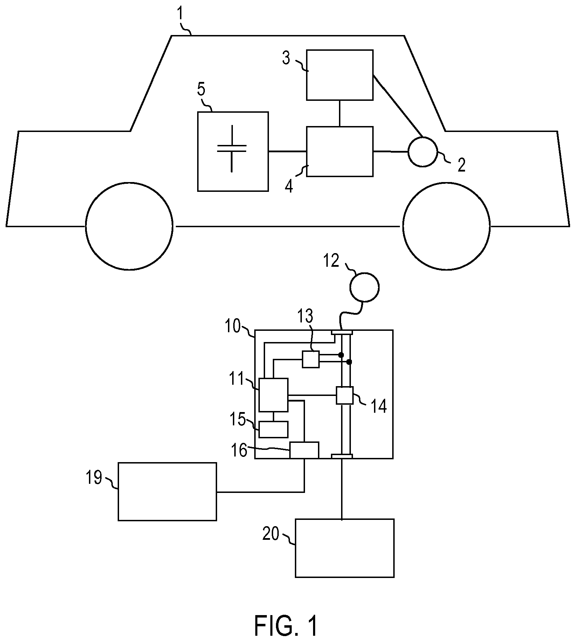

Figur 1 zeigt ein System mit einem Elektrofahrzeug 1 und einer Vorrichtung 10 zur Prüfung einer Traktionsbatterie 5. Das Elektrofahrzeug 1 umfasst einen (nicht dargestellten) Elektroantrieb, der von der Traktionsbatterie 5 mit Energie versorgt wird. Das Elektrofahrzeug 1 kann ein vollelektrisches Fahrzeug sein. Alternativ kann das Elektrofahrzeug 1 ein Hybridfahrzeug sein, das zusätzlich zu dem Elektroantrieb wenigstens einen weiteren Antrieb umfasst und das zusätzlich zu der Traktionsbatterie 5 wenigstens ein weiteres Energiespeichersystem für den weiteren Antrieb umfasst. Die Traktionsbatterie 5 kann beispielsweise mehrere miteinander verschaltete Akkumulatorenzellen oder Blöcke als Energiespeicher zum Antreiben des Elektrofahrzeugs 1 umfassen.

Das Elektrofahrzeug 1 umfasst die Traktionsbatterie 5 und eine Lade-Entlade-Elektronik 4, die eingerichtet ist, um die Traktionsbatterie 5 über eine Lade-Entlade-Schnittstelle wahlweise aufzuladen oder zu entladen. Das Elektrofahrzeug 1 kann als Lade-Entlade-Schnittstelle einen Lade-Entlade-Stecker 2 aufweisen. Der Lade-Entlade-Stecker 2 dient als Schnittstelle, mit dem das Elektrofahrzeug 1 mit einem Energienetz, beispielsweise mit einer Ladestation eines Energienetzes, oder bei einer Prüfung der Traktionsbatterie selektiv mit dem Prüfgerät 10 verbunden werden kann. Das Fahrzeug 1 kann eine Steuerelektronik 3 aufweisen, die ein Bordnetz mit einem Steuergerätoder mehreren Steuergeräten und/oder einen Bordcomputer umfassen kann.

Die Vorrichtung zur Prüfung der Traktionsbatterie kann als ein Prüfgerät 10 ausgestaltet sein. Das Prüfgerät 10 kann mobil, insbesondere tragbar sein. Das Prüfgerät 10 weist eine Schnittstelle 12 auf, die mit dem Lade-Entlade-Stecker 2 des Elektrofahrzeugs 1 lösbar koppelbar ist. Die Schnittstelle 12 kann eine Anordnung von elektrischen Kontakten und/oder von mechanischen Verbindungselementen umfassen, die der Anordnung von elektrischen Kontakten und/oder von mechanischen Verbindungselementen einer Ladestation zum Laden der Traktionsbatterie 5 des Elektrofahrzeugs über den Lade-Entlade-Stecker 2 entspricht.

Für eine Prüfung der Traktionsbatterie 5 wird die Schnittstelle 12 des Prüfgeräts 10 mit dem Lade-Entlade-Stecker 2 verbunden. Das Prüfgerät 10 löst einen Entladevorgang aus. Dazu kann das Prüfgerät 10 einen Steuerbefehl erzeugen, der entweder über den Lade-Entlade-Stecker 2 oder eine davon separate Schnittstelle des Elektrofahrzeugs 1 an das Elektrofahrzeug 1 übermittelt wird.

Als Antwort auf den Steuerbefehl kann die Traktionsbatterie 5 des Elektrofahrzeugs möglichst vollständig entladen werden. Bei einigen Elektrofahrzeugen kann die Lade-Entlade-Elektronik 4 des Elektrofahrzeugs 1 so eingerichtet sein, dass sie kein vollständiges Entladen der Traktionsbatterie 5 erlaubt. In diesem Fall kann die Lade-Entlade-Elektronik 4 den Entladevorgang als Antwort auf den Steuerbefehl so steuern, dass die Traktionsbatterie 5 so weit entladen wird, wie dies die Lade-Entlade-Elektronik 4 bei der Batterieprüfung zulässt.

Wenigstens während des durch den Steuerbefehl ausgelösten Entladevorgangs kann das Prüfgerät 10 den Energiefluss überwachen, der während des Entladevorgangs von der Traktionsbatterie 5 über den Lade-Entlade-Stecker 2 zu dem Prüfgerät 10 gerichtet ist. Das Überwachen des Entladevorgangs kann ein Überwachen der Stromstärke des von der Traktionsbatterie 5 über den Lade-Entlade-Stecker 2 zu dem Prüfgerät 10 fließenden Entladestroms umfassen. Alternativ oder zusätzlich kann das Überwachen des Entladevorgangs ein Bestimmen einer gesamten elektrischen Ladung umfassen, die von der Traktionsbatterie 5 über den Lade-Entlade-Stecker 2 zu dem Prüfgerät 10 fließt. Dazu kann eine Stromstärke des Entladestroms überwacht und beispielsweise rechnerisch integriert werden. Alternativ oder zusätzlich kann das Überwachen des Entladevorgangs ein Überwachen der elektrischen Leistung umfassen, die von der Traktionsbatterie 5 über den Lade-Entlade-Stecker 2 bereitgestellt wird. Alternativ oder zusätzlich kann das Überwachen des Entladevorgangs ein Bestimmen der gesamten Energie umfassen, die von der Traktionsbatterie 5 während des Entladevorgangs bereitgestellt wird. Dazu kann die Leistung überwacht und beispielsweise rechnerisch integriert werden.

Die entsprechenden Überwachungsfunktionen können von einer Überwachungseinheit 11 des Prüfgeräts 10 ausgeführt werden. Die Überwachungseinheit 11 kann einen oder mehrere Prozessoren, Mikroprozessoren, Controller, Mikrocontroller, anwendungsspezifische Spezialschaltungen (ASIC) und/oder andere integrierte Halbleiterschaltungen oder eine Kombination davon umfassen. Die Überwachungseinheit 11 kann wenigstens einen Messwiderstand zum Erfassen des Ausgangsstroms des Elektrofahrzeugs 1 umfassen.

Während des Entladevorgangs kann die Ausgangsleistung und/oder Ausgangsstromstärke, die von dem Elektrofahrzeug 1 beim Entladen der Traktionsbatterie 5 bereitgestellt wird, und/oder die Entladegeschwindigkeit zeitabhängig in einem Lastzyklus (der in der Technik auch als Belastungszyklus bezeichnet wird) verändert werden. Bei der Überwachung des Entladevorgangs kann das Prüfgerät den elektrischen Strom und/oder die Leistung zeitabhängig überwachen und mit mehreren verschiedenen Lastniveaus, die während des Lastzyklus eingestellt werden, korrelieren. Der Lastzyklus kann von dem Prüfgerät 10 gesteuert werden. Dazu kann das Prüfgerät 10 Steuerbefehle zur Laständerung erzeugen, die entweder über den Lade-Entlade-Stecker 2 oder eine davon separate Schnittstelle des Elektrofahrzeugs 1 an das Elektrofahrzeug 1 bereitgestellt werden. Alternativ oder zusätzlich kann das Prüfgerät 10 eine zeitlich veränderliche Last für das Elektrofahrzeug bereitstellen, um einen Lastzyklus zu fahren.

Der Lastzyklus kann vordefiniert und in einem Speicher 15 hinterlegt sein. Alternativ oder zusätzlich kann der Lastzyklus durch einen Benutzer konfigurierbar sein. Die Erzeugung und Aussteuerung der Steuerbefehle zur Laständerung kann durch die Überwachungseinheit 11 erfolgen. Die Überwachungseinheit 15 kann die Steuerbefehle zur Laständerung über die Schnittstelle 12 an das Elektrofahrzeug 1 aussteuern. Alternativ oder zusätzlich kann ein Lastzyklus auch durch Einstellung wenigstens eines Parameters eines Lastkreises des Prüfgeräts 10 erfolgen. Der Lastkreis kann beispielsweise einer Rückspeiseschaltung 14 zur Rückspeisung von Energie in ein elektronisches Netz 20 umfassen. Die Rückspeiseschaltung 14 kann in das Prüfgerät 10 integriert sein.

Wenigstens während des Entladevorgangs kann das Prüfgerät 10 über die Schnittstelle 12 und den Lade-Entlade-Stecker 2 des Elektrofahrzeugs 1 mit Energie versorgt werden. Das Prüfgerät 10 kann eingerichtet sein, um bereits dann von dem Elektrofahrzeug 1 über die Schnittstelle 12 mit Energie versorgt zu werden, wenn der Lastzyklus konfiguriert und/oder der Steuerbefehl, der den Entladevorgang auslöst, erzeugt wird. Das Prüfgerät 10 kann eine Versorgungsschaltung 13 aufweisen, die mit der Schnittstelle 12 gekoppelt ist. Die Versorgungsschaltung 13 kann eingerichtet sein, um eine Versorgungsspannung für die Überwachungseinheit 11 und/oder andere Elemente des Prüfgeräts 10 aus dem Energiefluss zu erzeugen, der während des Entladevorgangs über den Lade-Entlade-Stecker 2 des Elektrofahrzeugs 1 zum Prüfgerät 10 fließt.

Das Prüfgerät 10 kann eingerichtet sein, um während des Entladevorgangs die von der Traktionsbatterie 5 entladene Energie in ein elektrisches Netz 20 zurückzuspeisen. Das Prüfgerät 10 kann dazu die Rückspeiseschaltung 14 umfassen. Die Rückspeiseschaltung 14 kann wenigstens einen Wandler oder einen anderen Konverter umfassen, um eine Rückspeisung des Ausgangsstroms des Elektrofahrzeugs 1 in das elektrische Netz 20 zu erlauben. Das elektrische Netz 20 kann ein Gebäudenetz sein. Das elektrische Netz 20 kann ein Energienetz eines Energieversorgers sein. Das elektrische Netz 20 ist ein fest installiertest Netz, das von einem Bordnetz des Elektrofahrzeugs verschieden ist.

Durch die Rückspeisung wird sichergestellt, dass die von der Traktionsbatterie 5 entladene Energie nicht einfach dissipiert wird, sondern an andere Verbraucher bereitgestellt werden kann. Dies kann die Kosten der Batterieprüfung verringern. Während des Entladevorgangs kann ein erster Teil der von der Traktionsbatterie 5 entladenen Energie zur Versorgung des Prüfgeräts 10 umgesetzt werden. Ein zweiter Teil der von der Traktionsbatterie 5 entladenen Energie kann zur Rückspeisung in das elektrische Netz 20 umgesetzt werden. Zur Rückspeisung von Energie in das elektrische Netz 20 wird das Prüfgerät 10 lösbar, beispielsweise über eine herkömmliche Netzsteckdose, mit dem elektrischen Netz 20 verbunden.

Zusätzlich zu wenigstens einem Entladevorgang kann das Prüfgerät 10 eingerichtet sein, um wenigstens einen Ladevorgang der Traktionsbatterie 5 zur Batterieprüfung zu steuern. Beispielsweise kann das Prüfgerät 10 zur Prüfung der Traktionsbatterie 5 die Traktionsbatterie 5 zunächst vollständig entladen und dann vollständig laden. Anschließend kann optional ein weiterer Entladevorgang ausgeführt werden. Zum Prüfen der Traktionsbatterie kann das Prüfgerät 10 aus dem Verhältnis zwischen Entladeenergie und Ladeenergie einen Wirkungsgrad der Traktionsbatterie 5 mit der zugeordneten Leistungselektronik ermitteln. Die Ermittlung des Wirkungsgrads kann in Abhängigkeit von der Lade- und Entladegeschwindingkeit und/oder in Abhängigkeit von der Lade- und Entladeleistung bestimmt werden.

Das Prüfgerät 10 kann eine Benutzerschnittstelle aufweisen. Über die Benutzerschnittstelle kann eine Prüfung gestartet und/oder konfiguriert werden. Beispielsweise können die Lade- und/oder Entladeleistungen, die Lade- und/oder Entladegeschwindigkeiten, der Zeitablauf etc. eines Lastzyklus benutzerdefiniert ausgewählt oder konfiguriert werden. Alternativ oder zusätzlich kann das Prüfgerät 10 eine Schnittstelle 16 zur Kopplung mit einem externen Rechner, beispielsweise einem tragbaren Computer 19, umfassen.

Die Steuerbefehle zum Auslösen des Entladevorgangs und etwaige weitere Steuerbefehle, mit denen beispielsweise ein Lastzyklus gefahren und/oder ein Ladevorgang eingeleitet wird, können auf unterschiedliche Weise an das Elektrofahrzeug bereitgestellt werden. Bei der in Figur 1 dargestellten Ausgestaltung weist die Schnittstelle 12 des Prüfgeräts 10 wenigstens einen Anschluss auf, über den Steuerbefehle übertragen werden können. Der Lade-Entlade-Stecker 2 des Elektrofahrzeugs weist einen korrespondierenden Anschluss zum Empfangen der Steuerbefehle auf. Die Steuerbefehle können von der Steuerelektronik 3 und/oder der Lade-Entlade-Elektronik 4 weiter verarbeitet werden.

Die Steuerbefehle können jeweils gemäß einem V2G-Protokoll erzeugt werden. Die Auswertung entsprechender Steuerbefehle des V2G-Protokolls ist in dem Elektrofahrzeug 1 für V2G-Funktionen implementiert. Der Steuerbefehl, mit dem zur Batterieprüfung der Entladevorgang der Traktionsbatterie 5 ausgelöst wird, kann derselbe Steuerbefehl sein, mit dem in einem V2G-Betrieb ohne Batterieprüfung das Elektrofahrzeug 1 zur Rückspeisung von Energie in das elektrische Netz 20 veranlasst wird. Alternativ kann der Steuerbefehl, mit dem zur Batterieprüfung der Entladevorgang der Traktionsbatterie 5 ausgelöst wird, ein für die Batterieprüfung reservierter Steuerbefehl des V2G-Protokolls sein, der für normale V2G-Anwendungen nicht verwendet wird. Beispielsweise kann der Steuerbefehl, mit dem zur Batterieprüfung der Entladevorgang der Traktionsbatterie 5 ausgelöst wird, eine weitergehende Entladung der Traktionsbatterie 5 erlauben als Steuerbefehle zur Entladung in herkömmlichen V2G-Anwendungen. Das Elektrofahrzeug 1 kann eingerichtet sein, um die Steuerbefehle umzusetzen und um abhängig von dem Steuerbefehl unterschiedliche Entladevorgänge für die Batterieprüfung und für herkömmliche V2G-Anwendungen, bei denen ohne Batterieprüfung eine Rückspeisung von Energie in das elektrische Netz 20 erfolgt, auszuführen.

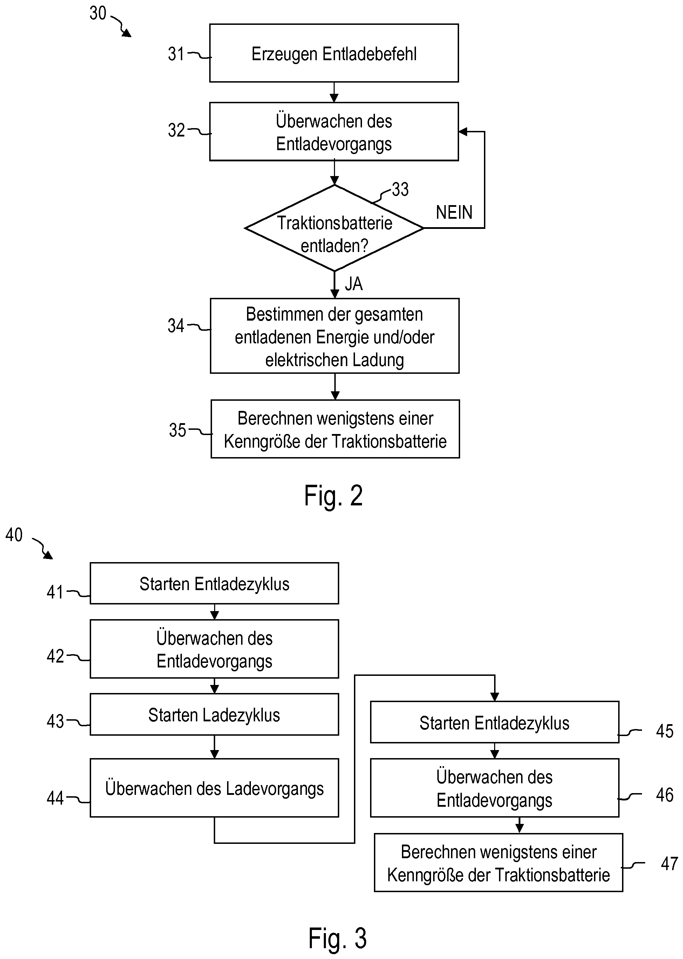

Das Prüfgerät 10 kann für eine Vielzahl unterschiedlicher Verfahren zur Batterieprüfung eingerichtet sein. Beispielhafte Verfahren werden unter Bezugnahme auf Figur 2 bis Figur 4 näher beschrieben.

Figur 2 ist ein Flussdiagramm eines Verfahrens 30 zur Prüfung einer Traktionsbatterie. Das Verfahren 30 kann von dem Prüfgerät 10 automatisch ausgeführt werden. Dazu wird eine Schnittstelle 12 des Prüfgeräts 10 mit dem Lade-Entlade-Stecker 2 des Elektrofahrzeugs 1 gekoppelt.

Bei Schritt 31 wird ein Steuerbefehl zum Entladen der Traktionsbatterie erzeugt. Der Steuerbefehl kann über die Schnittstelle 12 des Prüfgeräts 10 und den Lade-Entlade-Stecker 2 an das Elektrofahrzeug 1 übermittelt werden. Der Steuerbefehl kann gemäß einem V2G-Protokoll erzeugt werden.

Bei Schritt 32 wird der Entladevorgang überwacht. Dazu kann beispielsweise eine Stromstärke, eine gesamte elektrische Ladung, eine Ausgangsleistung des Elektrofahrzeugs oder eine gesamte elektrische Energie bestimmt werden.

Bei Schritt 33 kann überprüft werden, ob der Entladevorgang abgeschlossen ist. Bei dem Verfahren 30 kann die Traktionsbatterie so weitgehend entladen werden, wie dies die Lade-Entlade-Elektronik 4 des Elektrofahrzeugs 1 zulässt. Das Ende des Entladevorgangs kann durch das Elektrofahrzeug 1 signalisiert oder von dem Prüfgerät 10 beispielsweise basierend auf einem Wert und/oder einer zeitlichen Änderung des Ausgangsstroms des Elektrofahrzeugs 1 automatisch erkannt werden. Wenn der Entladevorgang noch nicht abgeschlossen ist, wird das Überwachen bei Schritt 32 fortgesetzt.

Bei Schritt 34 kann optional eine gesamte elektrische Energie und/oder eine gesamte elektrische Ladung, die während des Entladevorgangs durch die Traktionsbatterie über den Lade-Entlade-Stecker 2 bereitgestellt wurde, bestimmt werden. Dazu kann die Leistung und/oder der Ausgangsstrom, der bei Schritt 32 erfasst wurde, rechnerisch integriert werden.

Bei Schritt 35 kann wenigstens eine Kenngröße für den Zustand der Traktionsbatterie 5 berechnet oder auf andere Weise bestimmt werden. Als Kenngröße kann beispielsweise der maximal netto verfügbare Energieinhalt der Traktionsbatterie bestimmt werden, der durch zeitliche Integration der Ausgangsleistung des Elektrofahrzeugs an dem Lade-Entlade-Stecker 2 ermittelt werden kann. Die Kenngröße kann aus dem Entladeverhalten bei verschiedenen Leistungen berechnet werden, beispielsweise wenn die Entladeleistung und/oder Entladegewschwindigkeit in einem Lastzyklus verändert wird.

Die Kenngröße kann über eine Benutzerschnittstelle des Prüfgeräts 10 ausgegeben und/oder in dem Prüfgerät 10 nichtflüchtig gespeichert werden.

Die Batterieprüfung kann zusätzlich zu einem Entladevorgang auch wenigstens einen Ladevorgang oder wenigstens einen weiteren Entladevorgang umfassen. Dies erlaubt beispielsweise die Bestimmung des Wirkungsgrads, der als Verhältnis zwischen der beim Entladen maximal über den Lade-Entlade-Stecker 2 bereitgestellten Entladeenergie und der zum vollständigen Laden erforderlichen Ladeenergie definiert werden kann.

Figur 3 ist ein Flussdiagramm eines Verfahrens 40 zur Prüfung einer Traktionsbatterie. Das Verfahren 40 kann von dem Prüfgerät 10 automatisch ausgeführt werden. Dazu wird eine Schnittstelle 12 des Prüfgeräts 10 mit dem Lade-Entlade-Stecker 2 des Elektrofahrzeugs 1 gekoppelt. Das Prüfgerät 10 wird mit einem elektrischen Netz 20 gekoppelt.

Bei Schritt 41 wird ein Entladezyklus gestartet, um die Traktionsbatterie 5 möglichst vollständig zu entladen. Bei Schritt 42 kann optional der Entladevorgang überwacht werden. Dies ist jedoch nicht unbedingt erforderlich, da die erforderliche Datenerfassung und Auswertung zur Batterieprüfung auch während eines späteren Entladevorgangs bei Schritt 46 erfolgen kann.

Bei Schritt 43 wird nach dem Entladen der Traktionsbatterie 5 ein Ladevorgang gestartet. Bei Schritt 44 wird der Ladevorgang überwacht. Dies kann ein Überwachen der über die Schnittstelle 12 und den Lade-Entlade-Stecker 2 zum Elektrofahrzeug 1 fließenden Energie und/oder Leistung umfassen. Bei Schritt 44 kann die gesamte Ladeenergie ermittelt werden, beispielsweise durch Integration der Leistung oder der Stromstärke beim Ladevorgang.

Bei Schritt 45 wird ein weiterer Entladezyklus gestartet, nachdem die Traktionsbatterie 5 vollständig geladen wurde. Bei Schritt 46 wird der Entladevorgang überwacht. Das Überwachen des Entladevorgangs kann wie unter Bezugnahme auf Schritt 32 des Verfahrens 30 beschrieben erfolgen.

Bei Schritt 47 kann wenigstens eine Kenngröße für den Zustand der Traktionsbatterie 5 berechnet oder auf andere Weise bestimmt werden. Als Kenngröße kann beispielsweise der maximal netto verfügbare Energieinhalt der Batterie bestimmt werden, der durch zeitliche Integration der Ausgangsleistung des Elektrofahrzeugs an dem Lade-Entlade-Stecker 2 ermittelt werden kann. Als Kenngröße kann zusätzlich oder alternativ der Wirkungsgrad berechnet werden, der als Verhältnis zwischen der beim Entladen maximal über den Lade-Entlade-Stecker 2 bereitgestellten Entladeenergie und der zum vollständigen Laden erforderlichen Ladeenergie definiert sein kann.

Beim Laden und/oder Entladen der Traktionsbatterie 5 während der Prüfung kann das Prüfgerät 10 die Geschwindigkeit und/oder Leistung, mit der das Laden und/oder Entladen erfolgt, in einem Lastzyklus zeitabhängig verändern. Aus dem Verhalten, das die Traktionsbatterie 5 bei Vorgabe unterschiedlicher Geschwindigkeiten und/oder Leistungen beim Laden und/oder Entladen zeigt, kann ebenfalls eine Charakterisierung der Traktionsbatterie 5 erfolgen.

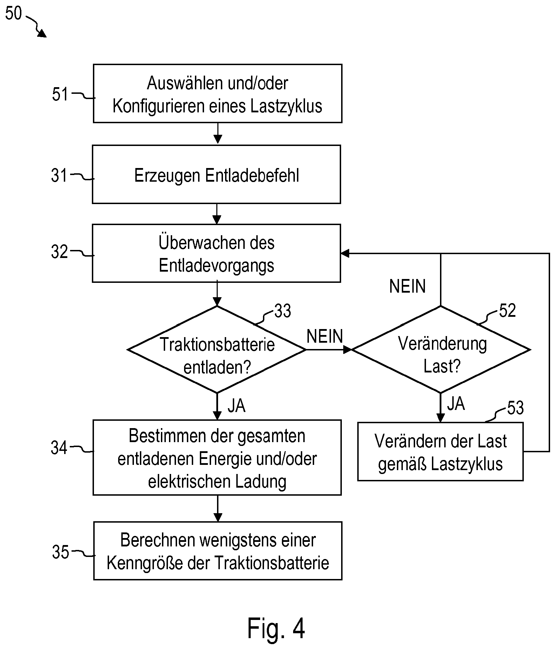

Figur 4 ist ein Flussdiagramm eines Verfahrens 50 zur Prüfung einer Traktionsbatterie. Das Verfahren 50 kann von dem Prüfgerät 10 automatisch ausgeführt werden. Dazu wird eine Schnittstelle 12 des Prüfgeräts 10 mit dem Lade-Entlade-Stecker 2 des Elektrofahrzeugs 1 gekoppelt. Das Prüfgerät 10 wird mit einem elektrischen Netz 20 gekoppelt.

Bei Schritt 51 kann ein Lastzyklus benutzerdefiniert oder automatisch ausgewählt und/oder konfiguriert werden. Beispielsweise kann einer von mehreren vordefinierten Lastzyklen ausgewählt werden, die in dem Prüfgerät 10 gespeichert sind.

Bei Schritten 31, 32 und 33 wird anschließend ein Steuerbefehl zum Initiieren des Entladevorgangs erzeugt, der Entladevorgang überwacht und überprüft, ob der Entladevorgang abgeschlossen ist. Diese Schritte können wie unter Bezugnahme auf Figur 2 beschrieben ausgeführt werden.

Falls bei Schritt 33 ermittelt wird, dass der Entladevorgang fortgesetzt wird, wird bei Schritt 52 überprüft, ob gemäß dem Lastzyklus eine Last verändert werden soll. Der Lastzyklus kann beispielsweise unterschiedliche Leistungen und/oder Entladegeschwindigkeiten als Funktion der Zeit definieren. Eine Änderung der Leistung und/oder der Entladegeschwindigkeit kann von dem Prüfgerät 10 zu den Zeitpunkten vorgenommen werden, zu denen der Lastzyklus eine entsprechende Laständerung vorsieht. Falls bei Schritt 52 ermittelt wird, dass die Last verändert werden soll, kann bei Schritt 53 die Last entsprechend dem Lastzyklus neu eingestellt werden. Das Verfahren kehrt dann zu Schritt 32 zurück, um die Überwachung des Entladevorgangs zeitabhängig fortzusetzen.

Das Einstellen einer neuen Last kann ein Übermitteln eines Steuerbefehls an die Lade-Entlade-Elektronik des Elektrofahrzeugs umfassen. Alternativ oder zusätzlich kann das Prüfgerät selbst die Last verändern. Beispielsweise kann ein Lastverhalten des Prüfgerätes 10 verändert werden, so dass sich ein anderer Stromfluss und dadurch eine andere Leistungsentnahme einstellt. Zum Verändern der Last kann eine einstellbare Komponente des Prüfgeräts kontrolliert beeinflusst werden. Beispielsweise kann wenigstens eine Schaltungskomponente der Rückspeiseschaltung 14 des Prüfgeräts 10, z.B. die Schaltfrequenz einer getakteten Wandlerschaltung, ein einstellbarer Widerstand, eine einstellbare Kapazität etc., beeinflusst werden, um das Lastverhalten zu ändern. Durch die kontrollierte Beeinflussung der wenigstens einen einstellbaren Komponente kann beispielsweise die von dem Elektrofahrzeug 2 in das elektrische Netz 20 zurückgespeiste Energie und somit der Stromfluss des Entladestroms und/oder die Leistungsentnahme verändert werden.

Wenn bei Schritt 33 ermittelt wird, dass der Entladevorgang abgeschlossen ist, kann bei Schritt 34 optional eine weitere rechnerische Verarbeitung der erfassten Daten erfolgen. Bei Schritt 35 kann eine Kenngröße der Traktionsbatterie rechnerisch ermittelt werden. Dazu kann das Entladeverhalten bei verschiedenen Leistungen und/oder Geschwindigkeiten weiter ausgewertet werden, um Rückschlüsse auf den Zustand der Traktionsbatterie 5 zu ziehen, beispielsweise um eine Alterung der Traktionsbatterie 5 zu erkennen.

Zahlreiche weitere Abwandlungen der beschriebenen Verfahren und Vorrichtungen können bei weiteren Ausführungsbeispielen implementiert sein. Beispielsweise kann das Steuergerät 10 auch eingerichtet sein, um Steuerbefehle zum Auslösen eines Entladevorgangs und/oder zur Steuerung eines Lastzyklus während des Entladevorgangs nicht über den Lade-Entlade-Stecker 2, sondern über eine davon separate Schnittstelle an das Elektrofahrzeug 1 zu übermitteln. Alternativ kann als PLC ("Power-Line-Communication") eine Energieübertragung zum Entladen und/oder Laden der Traktionsbatterie 5 über einen Steuerpin eines Lade-Entlade-Stecker 2 erfolgen.

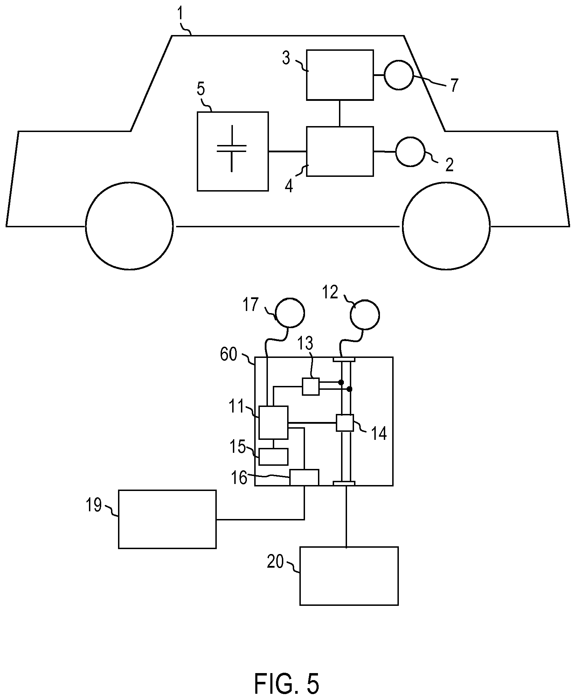

Figur 5 zeigt ein System mit einem Elektrofahrzeug 1 und einem Prüfgerät 60. Das Elektrofahrzeug 1 weist einen Lade-Entlade-Stecker 2 auf. Das Elektrofahrzeug 1 weist eine von dem Lade-Entlade-Stecker 2 separate Datenschnittstelle 7 auf. Die Steuerelektronik 3 und/oder Lade-Entlade-Elektronik 4 des Elektrofahrzeugs 1 kann mit der Datenschnittstelle 7 gekoppelt sein, um über die Datenschnittstelle 7 empfangene Steuerbefehle auszuwerten und umzusetzen.

Das Prüfgerät 60 weist eine Schnittstelle 12 zur Kopplung mit dem Lade-Entlade-Stecker 2 auf. Das Steuergerät weist eine von der Schnittstelle 12, über die der Entladestrom von dem Lade-Entlade-Stecker 2 empfangen wird, separate Schnittstelle 17 auf, über die der Steuerbefehl zum Auslösen des Entladevorgangs an das Elektrofahrzeug 1 übertragen werden kann. Die Datenschnittstelle 7 und die Schnittstelle 17 des Prüfgeräts können beispielsweise als RS232 oder USB-Schnittstellen ausgestaltet sein.

Die weitere Ausgestaltung und Funktionsweise des Prüfgeräts 60 entspricht der des Prüfgeräts 10.

Während Ausführungsbeispiele unter Bezugnahme auf die Figuren detailliert beschrieben wurden, können bei weiteren Ausführungsbeispielen alternative oder zusätzliche Merkmale verwendet werde. Während beispielsweise Steuerbefehle zum Auslösen eines Entladevorgangs digitale Befehle sein können, können die Steuerbefehle auch als analoge Signale implementiert sein.

Während bei Ausführungsbeispielen die von der Traktionsbatterie entladene Energie wenigstens teilweise in ein elektrisches Netz zurückgespeist werden kann, kann die entladene Energie alternativ auch dissipiert werden.

Während bei Ausführungsbeispielen das Prüfgerät zumindest während des Entladevorgangs von der Traktionsbatterie über den Lade-Entlade-Stecker mit Energie versorgt werden kann, kann alternativ das Prüfgerät auch während des Entladevorgangs der Traktionsbatterie von einem elektrischen Netz gespeist werden.

Während ein Lade-Entlade-Stecker als Lade-Entlade-Schnittstelle zum Laden und Entladen der Traktionsbatterie des Elektrofahrzeugs verwendet werden kann, kann alternativ auch eine andere Ausgestaltung der Lade-Entlade-Schnittstelle verwendet werden. Beispielsweise kann unter Verwendung einer induktiven Kopplung zwischen dem Prüfgerät und dem Elektrofahrzeug eine drahtlose Energieübertragung beim Laden und/oder Entladen erfolgen, so dass keine Steckkontakte benötigt werden. Dabei können dieselben Induktivitäten sowohl zum Laden als auch zum Entladen der Batterie eingesetzt werden.

Der Lade-Entlade-Stecker kann gemäß einer geeigneten Normung (beispielsweise IEC 62196) ausgestaltet sein. Es kann ein separater Anschlusskontakt für eine Übertragung von Steuerbefehlen vorgesehen sein. Alternativ oder zusätzlich können Steuerbefehle in einer PLC ("Power Line Communication")-Technik über die Anschlusskontakte übertragen werden, über die beim Laden und Entladen der Traktionsbatterie auch Energie übertragen wird. Beim Laden oder Entladen kann eine Energieübertragung über Steuerpins des Lade-Entlade-Steckers erfolgen, um eine PLC zu realisieren.

Verfahren, Vorrichtungen und Systeme nach Ausführungsbeispielen erlauben eine Batterieprüfung der Traktionsbatterie, die keine vorab vorhandenen Kenntnisse über das Elektrofahrzeug und dessen Bordsystem erfordert.

Verfahren, Vorrichtungen und Systeme nach Ausführungsbeispielen können insbesondere zur Prüfung der Traktionsbatterie eines vollelektrischen Fahrzeugs oder eines Hybridfahrzeugs verwendet werden.

## Patentansprüche

1. Verfahren zur Prüfung einer Traktionsbatterie (5) eines Elektrofahrzeugs (1), die über eine Lade-Entlade-Schnittstelle (2) sowohl ladbar als auch entladbar ist, wobei das Verfahren die folgenden Schritte umfasst:
- Erzeugen eines Steuerbefehls zum Auslösen eines Entladevorgangs der Traktionsbatterie (5),
- Überwachen des Entladevorgangs der Traktionsbatterie (5) und
- Ermitteln wenigstens einer Kenngröße der Traktionsbatterie (5) abhängig von dem überwachten Entladevorgang,
**dadurch gekennzeichnet, dass**
das Verfahren von einem mobilen Prüfgerät (10; 60) ausgeführt wird, und dass
eine Versorgungsschaltung (13) des Prüfgeräts (10; 60) eine Versorgungsspannung für wenigstens ein Element des Prüfgeräts (10; 60) aus einem Energiefluss erzeugt, der während des Entladevorgangs über die Lade-Entlade-Schnittstelle (2) zu dem Prüfgerät (10; 60) fließt.

2. Verfahren nach Anspruch 1,
wobei der Steuerbefehl über die Lade-Entlade-Schnittstelle (2) an das Elektrofahrzeug (1) übermittelt wird.

3. Verfahren nach Anspruch 2,
wobei der Steuerbefehl nach einem V2G-Protokoll erzeugt wird.

4. Verfahren nach Anspruch 3,
wobei der Steuerbefehl ein Befehl des V2G-Protokolls ist, mit dem in einem V2G-Netzbetrieb ein Einspeisen von Energie von der Traktionsbatterie (5) in ein Gebäudenetz oder ein Energienetz (20) ausgelöst wird.

5. Verfahren nach einem der Ansprüche 1 bis 3,
wobei der Steuerbefehl ein für die Prüfung der Traktionsbatterie (5) reservierter Steuerbefehl ist.

6. Verfahren nach Anspruch 1,
wobei der Steuerbefehl über eine von der Lade-Entlade-Schnittstelle (2) verschiedene Schnittstelle (7) des Elektrofahrzeugs (1) an das Elektrofahrzeug (1) übermittelt wird.

7. Verfahren nach einem der vorhergehenden Ansprüche,
wobei bei dem Entladevorgang wenigstens ein Teil der in der Traktionsbatterie (5) gespeicherten Energie in ein Gebäudenetz oder ein Energienetz (20) eingespeist wird.

8. Verfahren nach einem der vorhergehenden Ansprüche,
wobei das Überwachen des Entladevorgangs umfasst: Erfassen einer bei dem Entladevorgang aus der Traktionsbatterie (5) entladenen elektrischen Ladung und/oder elektrischen Energie.

9. Verfahren nach Anspruch 8,
wobei das Ermitteln der wenigstens einen Kenngröße der Traktionsbatterie (5) umfasst: Ermitteln einer Kapazität der Traktionsbatterie (5) abhängig von der bei dem Entladevorgang aus der Traktionsbatterie (5) entladenen elektrischen Ladung und/oder elektrischen Energie.

10. Verfahren nach Anspruch 8 oder Anspruch 9,
wobei das Ermitteln der wenigstens einen Kenngröße der Traktionsbatterie (5) umfasst: Ermitteln eines Systemwirkungsgrads abhängig von der der bei dem Entladevorgang aus der Traktionsbatterie (5) entladenen elektrischen Ladung und/oder elektrischen Energie.

11. Verfahren nach einem der vorhergehenden Ansprüche, umfassend:
- Auslösen eines Ladevorgangs der Traktionsbatterie (5) und
- Überwachen des Ladevorgangs der Traktionsbatterie (5),
wobei die wenigstens eine Kenngröße der Traktionsbatterie (5) abhängig von dem überwachten Ladevorgang und dem überwachten Entladevorgang ermittelt wird.

12. Verfahren nach einem der vorhergehenden Ansprüche,
wobei in dem Prüfgerät (10; 60) wenigstens ein vordefinierter und/oder benutzerkonfigurierbarer Belastungszyklus für den Entladevorgang hinterlegt ist.

13. Vorrichtung zur Prüfung einer Traktionsbatterie (5) eines Elektrofahrzeugs (1), die über eine Lade-Entlade-Schnittstelle (2) sowohl ladbar als auch entladbar ist, wobei die Vorrichtung (10; 60) umfasst:
- eine Schnittstelle (12; 17) zum Ausgeben eines Steuerbefehls zum Auslösen eines Entladevorgangs der Traktionsbatterie (5) und
- eine mit der Lade-Entlade-Schnittstelle (2) koppelbare Überwachungseinheit (11) zum Überwachen des Entladevorgangs der Traktionsbatterie (5) und zum Ermitteln wenigstens einer Kenngröße der Traktionsbatterie (5) abhängig von dem überwachten Entladevorgang,
**dadurch gekennzeichnet, dass**
dass die Vorrichtung ein mobiles Prüfgerät (10; 60) ist, und
dass die Vorrichtung weiter umfasst:
- eine Rückspeiseschaltung (14) zur Rückspeisung von Energie in ein elektronisches Netz (20), die in das Prüfgerät (10; 60) integriert ist und einen Konverter umfasst, und
- eine Versorgungsschaltung (13), die eingerichtet ist, um eine Versorgungsspannung für wenigstens ein Element des Prüfgeräts (10; 60) aus einem Energiefluss zu erzeugen, der während des Entladevorgangs über die Lade-Entlade-Schnittstelle (2) zu dem Prüfgerät (10; 60) fließt.

## Claims

1. Method for testing a traction battery (5) of an electric vehicle (1), which traction battery is both chargeable and dischargeable via a charging-discharging interface (2), wherein the method comprises the following steps:
- generating a control command for initiating a discharging process of the traction battery (5),
- monitoring the discharging process of the traction battery (5) and
- determining at least one characteristic quantity of the traction battery (5) depending on the monitored discharging process,
**characterized in that**
the method is carried out by a mobile testing apparatus (10; 60), and
a supply circuit (13) of the testing apparatus (10; 60) generates a supply voltage for at least one element of the testing apparatus (10; 60) from an energy flow which during the discharging process flows via the charging-discharging interface (2) to the testing apparatus (10; 60).

2. Method according to claim 1,
wherein the control command is transmitted via the charging-discharging interface (2) to the electric vehicle (1).

3. Method according to claim 2,
wherein the control command is generated according to a V2G protocol.

4. Method according to claim 3,
wherein the control command is a command of the V2G protocol, with which in a V2G network operation a feeding of energy from the traction battery (5) into a building network or an energy network (20) is initiated.

5. Method according to any one of claims 1 to 3,
wherein the control command is a control command reserved for testing the traction battery (5).

6. Method according to claim 1,
wherein the control command is transmitted via an interface (7) of the electric vehicle (1) to the electric vehicle (1), which interface is different from the charging-discharging-interface (2).

7. Method according to any one of the preceding claims,
wherein during the discharging process at least part of the energy stored in the traction battery (5) is fed into a building network or an energy network (20).

8. Method according to any one of the preceding claims,
wherein the monitoring of the discharging process comprises: detecting an electrical charge and/or electrical energy discharged from the traction battery (5) during the discharging process.

9. Method according to claim 8,
wherein the determining of the at least one characteristic quantity of the traction battery (5) comprises: determining a capacity of the traction battery (5) depending on the electrical charge and/or electrical energy discharged from the traction battery (5) during the discharging process.

10. Method according to claim 8 or claim 9,
wherein the determining of the at least one characteristic quantity of the traction battery (5) comprises: determining a system efficiency depending on the electrical charge and/or electrical energy discharged from the traction battery (5) during the discharging process.

11. Method according to any one of the preceding claims, comprising:
- initiating a charging process of the traction battery (5) and
- monitoring the charging process of the traction battery (5),
wherein the at least one characteristic quantity of the traction battery (5) is determined depending on the monitored charging process and the monitored discharging process.

12. Method according to any one of the preceding claims,
wherein at least one predefined and/or user-configurable load cycle for the discharging process is stored in the testing apparatus (10; 60).

13. Apparatus for testing a traction battery (5) of an electric vehicle (1), which traction battery is both chargeable and dischargeable via a charging-discharging interface (2),
wherein the apparatus (10; 60) comprises:
- an interface (12; 17) for outputting a control command for initiating a discharging process of the traction battery (5) and
- a monitoring unit (11), couplable to the charging-discharging interface (2), for monitoring the discharging process of the traction battery (5) and for determining at least one characteristic quantity of the traction battery (5) depending on the monitored discharging process,
**characterized in that**
the apparatus is a mobile testing apparatus (10; 60), and
the apparatus further comprises:
- a feedback circuit (14) for feeding energy back into an electronic network (20), which circuit is integrated in the testing apparatus (10; 60) and comprises a converter, and
- a supply circuit (13) which is configured to generate a supply voltage for at least one element of the testing apparatus (10; 60) from an energy flow which during the discharging process flows via the charging-discharging interface (2) to the testing apparatus (10; 60).

## Revendications

1. Procédé de contrôle d'une batterie de traction (5) d'un véhicule électrique (1) qui non seulement peut être chargée mais aussi déchargée par une interface de charge et décharge (2), dans lequel le procédé comporte les étapes suivantes :
- la génération d'un ordre de commande pour le déclenchement d'un processus de décharge de la batterie de traction (5),
- la surveillance du processus de décharge de la batterie de traction (5) et
- la détermination au moins d'une grandeur caractéristique de la batterie de traction (5) en fonction du processus de décharge surveillé,
**caractérisé en ce que**
le procédé est réalisé par un appareil de contrôle (10 ; 60) mobile, et qu'un circuit d'alimentation (13) de l'appareil de contrôle (10 ; 60) génère une tension d'alimentation pour au moins un élément de l'appareil de contrôle (10 ; 60) à partir d'un flux d'énergie qui s'écoule pendant le processus de décharge par l'interface de charge et décharge (2) vers l'appareil de contrôle (10 ; 60).

2. Procédé selon la revendication 1,
dans lequel l'ordre de commande est transmis par l'interface de charge et décharge (2) au véhicule électrique (1).

3. Procédé selon la revendication 2,
dans lequel l'ordre de commande est généré selon un protocole V2G.

4. Procédé selon la revendication 3,
dans lequel l'ordre de commande est un ordre du protocole V2G, avec lequel dans un mode de réseau V2G une injection d'énergie est déclenchée par la batterie de traction (5) dans un réseau de bâtiment ou un réseau d'énergie (20).

5. Procédé selon l'une des revendications 1 à 3,
dans lequel l'ordre de commande est un ordre de commande réservé pour le contrôle de la batterie de traction (5).

6. Procédé selon la revendication 1,
dans lequel l'ordre de commande est transmis par une interface (7) différente de l'interface de charge et décharge (2) du véhicule électrique (1) au véhicule électrique (1).

7. Procédé selon l'une quelconque des revendications précédentes,
dans lequel lors du processus de décharge au moins une partie de l'énergie stockée dans la batterie de traction (5) est injectée dans un réseau de bâtiment ou un réseau d'énergie (20).

8. Procédé selon l'une quelconque des revendications précédentes,
dans lequel la surveillance du processus de décharge comporte : la détection d'une charge électrique et/ou énergie électrique déchargée lors du processus de décharge de la batterie de traction (5).

9. Procédé selon la revendication 8,
dans lequel la détermination d'au moins une grandeur caractéristique de la batterie de traction (5) comporte : la détermination d'une capacité de la batterie de traction (5) en fonction de la charge électrique et/ou énergie électrique déchargée lors du processus de décharge de la batterie de traction (5).

10. Procédé selon la revendication 8 ou la revendication 9,
dans lequel la détermination d'au moins une grandeur caractéristique de la batterie de traction (5) comporte : la détermination d'un rendement de système en fonction de la charge électrique et/ou énergie électrique déchargée lors du processus de décharge de la batterie de traction (5).

11. Procédé selon l'une quelconque des revendications précédentes, comprenant :
- le déclenchement d'un processus de charge de la batterie de traction (5) et
- la surveillance du processus de charge de la batterie de traction (5),
dans lequel l'au moins une grandeur caractéristique de la batterie de traction (5) est déterminée en fonction du processus de charge surveillé et du processus de décharge surveillé.

12. Procédé selon l'une quelconque des revendications précédentes,
dans lequel au moins un cycle de chargement prédéfini et/ou configurable par l'utilisateur pour le processus de décharge est enregistré dans l'appareil de contrôle (10 ; 60).

13. Dispositif de contrôle d'une batterie de traction (5) d'un véhicule électrique (1), qui non seulement peut être chargée mais aussi déchargée par une interface de charge et décharge (2), dans lequel le dispositif (10 ; 60) comporte :
- une interface (12 ; 17) pour la sortie d'un ordre de commande pour le déclenchement d'un processus de décharge de la batterie de traction (5) et
- une unité de surveillance (11) pouvant être couplée à l'interface de charge et décharge (2) pour la surveillance du processus de décharge de la batterie de traction (5) et pour la détermination d'au moins une grandeur caractéristique de la batterie de traction (5) en fonction du processus de décharge surveillé,
**caractérisé en ce**
**que** le dispositif est un appareil de contrôle (10 ; 60) mobile, et
**que** le dispositif comporte en outre :
- un circuit d'alimentation de retour (14) pour l'alimentation de retour d'énergie dans un réseau électronique (20) qui est intégré dans l'appareil de contrôle (10 ; 60) et comporte un convertisseur, et
- un circuit d'alimentation (13) qui est aménagé afin de générer une tension d'alimentation pour au moins un élément de l'appareil de contrôle (10; 60) d'un flux d'énergie qui s'écoule pendant le processus de décharge par l'interface de charge et décharge (2) vers l'appareil de contrôle (10 ; 60).
